# EUROPEAN PATENT SPECIFICATION

(11) **EP 2 859 588 B1**
(45) Date of publication and mention of the grant of the patent: **21.12.2016**
(21) Application number: 13733088.2
(22) Date of filing: 05.06.2013
(51) Int. Cl.: G01N 27/414, H01L 29/06, H01L 29/66, H01L 21/02, B82Y 40/00, H01L 29/775, B82Y 10/00, H01L 29/10

(54) **A METHOD OF MANUFACTURING A STRUCTURE COMPRISING ELONGATE NANOSTRUCTURES ADAPTED TO BE TRANSFERRED TO A NON-CRYSTALLINE LAYER**
VERFAHREN ZUR HERSTELLUNG EINER STRUKTUR MIT LÄNGLICHEN NANOSTRUKTUREN ZUR ÜBERTRAGUNG AUF EINE NICHTKRISTALLINE SCHICHT
PROCÉDÉ DE FABRICATION D'UNE STRUCTURE À NANOSTRUCTURES ÉLONGÉES CONÇUE POUR ÊTRE TRANSFÉRÉE VERS UNE COUCHE NON CRISTALLINE

(30) Priority: 07.06.2012 US 201261656617 P
(43) Date of publication of application: 15.04.2015
(73) Proprietor: QuNano AB, 223 70 Lund (SE)
(72) Inventor: OHLSSON, Jonas, S-212 13 Malmö (SE); SAMUELSON, Lars, S-211 19 Malmö (SE); TEGENFELDT, Jonas, S-226 47 Lund (SE); ÅBERG, Ingvar, S-245 32 Staffanstorp (SE); ASOLI, Damir, S-238 37 Oxie (SE)
(74) Representative: Neij & Lindberg AB
(86) International application number: PCT/SE2013/050649
(87) International publication number: WO 2013/184065

(56) References cited:
- EP-A2- 1 796 172
- WO-A1-2008/047847
- WO-A2-03/093169
- US-A1- 2005 227 391
- US-A1- 2006 134 883
- US-A1- 2010 075 024

## Description

### TECHNICAL FIELD

The disclosure relates to a method of manufacturing a structure comprising elongate nanostructures and being adapted to be transferred to a non-crystalline layer and to a structure manufactured using said method.

### BACKGROUND

A nanowire is an elongate structure having a nanosized diameter, usually less than 500 nm, and typically exhibiting aspect ratio (length-to-width ratio) of around 10 or more. The properties of the nanowires can enable more efficient use of materials in solar cells and in light emitting diodes. This is disclosed in applicant's own US-patent application 2010/0186809, and granted US-patents 8227817 and 8183587. Furthermore, as disclosed in applicant's granted US-patent 7335908, the small dimensions enable flexible use of heterostructures and material combinations not available in bulk material. At these scales, quantum mechanical effects are important. A consequence thereof is that nanowires and thereto similar structures have many interesting properties not present in bulk or 3-D materials. This is because electrons in nanowires are quantum confined laterally and thus occupy energy levels that are different from the traditional continuum of energy levels or bands found in bulk materials. There are many applications where nanowires may become important, e.g. in electronic, optoelectronic, fluidic and biological nanosized devices.

In these nanowire based devices a plurality of nanowires, both hollow and solid, is usually arranged in ordered arrays on a substrate. The substrate often has multiple purposes, i.e. acting as a template for nanowire growth, being a carrier for the nanowires in the device and electrically connecting the nanowires. Different techniques for growth of the ordered arrays of nanowires are known. For example, semiconductor nanowires may be epitaxially grown on a monocrystalline substrate, typically by arranging a patterned growth mask on the substrate, as described in e.g. WO 2007/102781. Another common method, described in US 7335908, is the so called VLS (vapour-liquid-solid) technique where a pattern of catalytic particles positioned on a standard Si-substrate is used as seeds to grow nanowires.

WO2008/047847 describes a method of separately encapsulating groups of low dimensional structures in a matrix. After encapsulation, a first group of low dimensional structures may be separated from a second group each group may then be processed, e.g by transfer to another substrate.

US2006/134883 describes methods for providing electrical contacts to an array of substantially vertically aligned nanorods. The nanorod array may be fabricated on top of a conducting layer that serves as a bottom contact to the nanorods. A top metal contact may be applied to a plurality of nanorods of the nanorod array, and the contacts may allow current/voltage characteristics of the nanorods to be measured.

One important limitation of these devices, at least with respect to biological applications and more specifically related to their implantation into a body, is that nanowires of these nanosized devices are grown on mechanically rigid substrates. Accordingly, in case of in vivo implantation of such a device, the rigidness of the substrate in itself may cause an adverse reaction from the body. In the same context of in vivo implantation, it is desirable to minimize the invasive effect of the surgery, e.g. by making the smallest possible incision.

Still with respect to biological applications, integration of advanced fluidics, e.g. to inject as well as aspirate small amounts of molecules and/or fluids to and from cells, is difficult using standard substrates. On the more general level, controlled transport of molecules and/or fluids, crucial for many applications of the nanowire based devices within the biological field, cannot be achieved using known art, i.e. devices where nanowires have been grown or deposited on rigid substrates. Also, integration of optical waveguides and other optical elements in the nanowire based devices is difficult using standard substrates.

At present, it is still to be shown how, for use in nanosized devices, to grow nanowires and thereto similar structures on substrates, preferably reusable for cost reasons, exhibiting properties other than those stated above so as to render these devices suitable for, in particular but not limited to, biological applications. One objective of the present invention is therefore to eliminate at least some of the drawbacks associated with the current art. A further challenge is to fully do away with substrate-promoted nanowire growth and propose a production technology creating devices of the above-discussed kind that, beside biological applications, also may be employed in solar cells

(flexible as well as non-flexible), LED-films and in flexible electronics. Further electronic and opto-electronic applications employing these devices, photodetectors, diodes, transistors, capacitors, resistors, e.g. 3D-integration of nanowire-based IC, should also be envisaged.

A further objective of the present invention is therefore to provide structures, preferably created by means of production technologies free from use of conventional rigid substrates, said structures being readily integrable into these devices.

### SUMMARY

The above stated objectives are achieved by a method of manufacturing a structure comprising a plurality of elongate nanostructures adapted to be transferred to a non-crystalline layer according to claim 1, and by the embodiments according to the dependent claims.

A first aspect of the present invention provides a method of transferring nanostructures to a substrate of choice, by way of example a soft polymer film.

In this context, term exposure as regards the extremity of a nanostructure is to be construed as comprising arrangements where extremity of the respective nanostructure is protruding from the layer as well as arrangements where the end section of the respective nanostructure is positioned flush to the surface of the layer.

By executing the steps of the above method, a structure comprising a plurality of nanostructures, either hollow or solid, is obtained, wherein said structure is readily transferrable to a novel, non-crystalline, substrate. This is achieved by deposition of the at least one layer of material that after removal of the original substrate becomes the lowermost layer. Lower section of the respective nanostructure is then firmly embedded in said layer of material. Therefore, the entire structure is structurally stable. Once a portion of this embedding layer is removed, at least the extremity of each nanostructure becomes exposed. It is hereby ensured that each nanostructure, after having been transferred to a novel substrate, is in direct contact with the novel substrate. In case of tubular nanostructures this opens for applications within the field of biofluidics whereby each nanostructure of the transferred structure, when connected to a reservoir containing source material, may be used as an introduction device for introducing this source material, e.g. molecules and/or fluids, into cells. In case of solid nanostructures used inter alia within the field of biofluidics, the exposure of the extremity of each nanostructure makes possible to, via a novel conductive substrate, simultaneously apply voltage to all nanostructures making up the structure.

Thus, the claimed method provides significant improvements when it comes to creating a structure comprising elongate nanostructures such as nanowires where said structure is transferrable to a novel substrate. Depending on the application, employment of the created structure opens for numerous beneficial effects. In this context, properties of the novel substrate onto which the created structure is positioned may be tailored to fit a particular application.

Further advantages and features of embodiments will become apparent when reading the following detailed description in conjunction with the drawings.

### BRIEF DESCRIPTION OF THE DRAWINGS

Figs. 1a-1e schematically illustrate a method of manufacturing a transferrable structure comprising a plurality of nanostructures according to one embodiment of the present invention.
Figs. 2a-2g schematically illustrate another method of manufacturing a transferrable structure comprising a plurality of nanostructures according to a different embodiment of the present invention.
Fig. 3 shows an exemplary device including a structure manufactured using claimed method, said device comprising hollow nanostructures and being suitable for application within the field of biofluidics.
Figs. 4a - 8 show a versatile nanowire-based structure according to another embodiment of the present invention.

### DETAILED DESCRIPTION

The present invention will now be described more fully hereinafter with reference to the accompanying drawings, in which preferred embodiments are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, like reference signs refer to like elements.

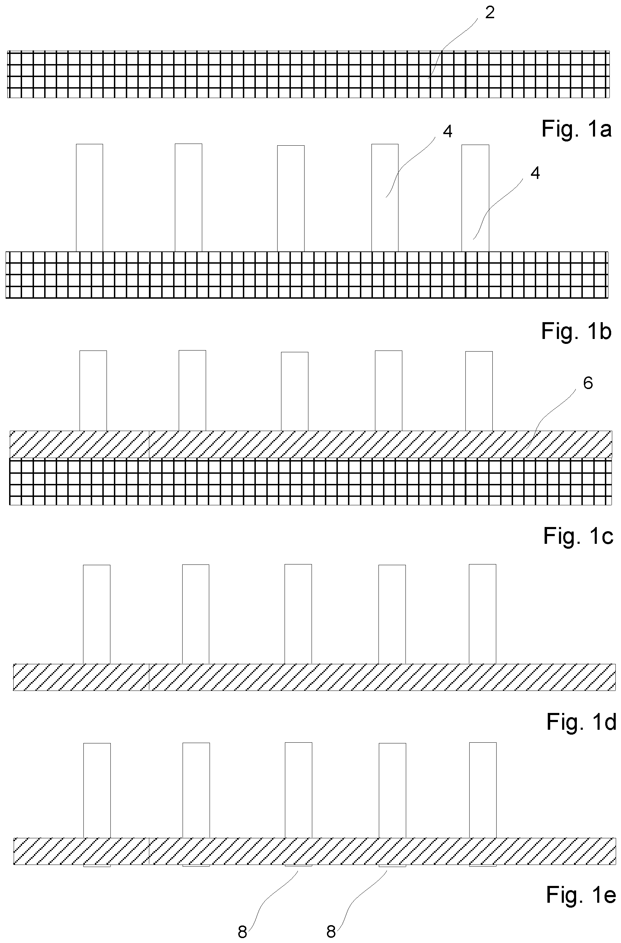

Figs. 1a-1e schematically illustrate a method of manufacturing a transferrable structure comprising a plurality of nanostructures according to one embodiment of the present invention.

Here, the term nanostructure may refer to the nanowire itself, or it may refer to a novel nanosized structure created using the nanowire as a starting point.

More specifically, in a first method step, illustrated in Fig. 1a, a substrate (2) having crystal orientation is provided. Typically, a conventional Si-substrate is used. As is known in the art, its crystal plane orientation is, using Miller indices, (001). Thereafter, in a second method step, a plurality of elongate nanostructures (4) such as nanowires is provided on said substrate. In a broadest sense, the elongate nanostructure may be any nanosized structure growing from a surface or that can be deposited onto a surface. Accordingly, it could be a semiconductor nanowire made in Si, GaP, InP, GaAs and grown epitaxially from a nanoscale catalytic gold particle on the substrate.

For fluidics applications the nanowires are assumed to be hollow, whereas solid nanowires can be considered for example for sensor, cell guidance, light emission, and solar-cell applications.

These nanowires extend from the substrate such that the angle defined by the axis of elongation of each nanostructure and the surface normal of the substrate is smaller than 55 degrees. In a non-limiting embodiment shown in Fig 1b, axis of elongation of each nanowire coincides with the surface normal of the substrate. Consequently, the shown nanowires are (001)-oriented as well. It is however equally conceivable that the provided nanowires grow in either (011) or (111) direction. Regardless of choice of the substrate and which of the above directions is adopted, the angle defined by the axis of elongation of each nanostructure and the surface normal of the substrate is always smaller than 55 degrees. The nanowires may be in-situ grown or precisely deposited. Alternatively, provided nanowires may be less precisely arranged, such as nanowires deposited using aerotaxy. In this context, it is possible that nanowires having different orientations are present on the same substrate.

In a further step, illustrated in Fig. 1c, at least one layer of material (6) is deposited such that at least the exposed regions of the substrate are covered by said material. The term exposed should here be construed as synonymous with not being covered by the nanowire. In order to further strengthen the bond between the nanowires and the future substrate, e.g. a polymer film exhibiting dielectric properties and being deposited by spinning, in-situ synthesis or in-situ polymerization, nanowires could adopt tree-like structures. In a variant, the deposited layer, typically a polymer, is a single layer. According to the invention, said depositing step comprises deposition of at least two layers, wherein an oxide material (not shown) is isotropically deposited directly onto the substrate whereafter a polymer layer (6) is deposited thereupon. In a subsequent step of the method, illustrated in Fig. 1d, the substrate is removed such that the deposited layer becomes lowermost layer. After the removal of the substrate, the oxide layer is also completely removed.

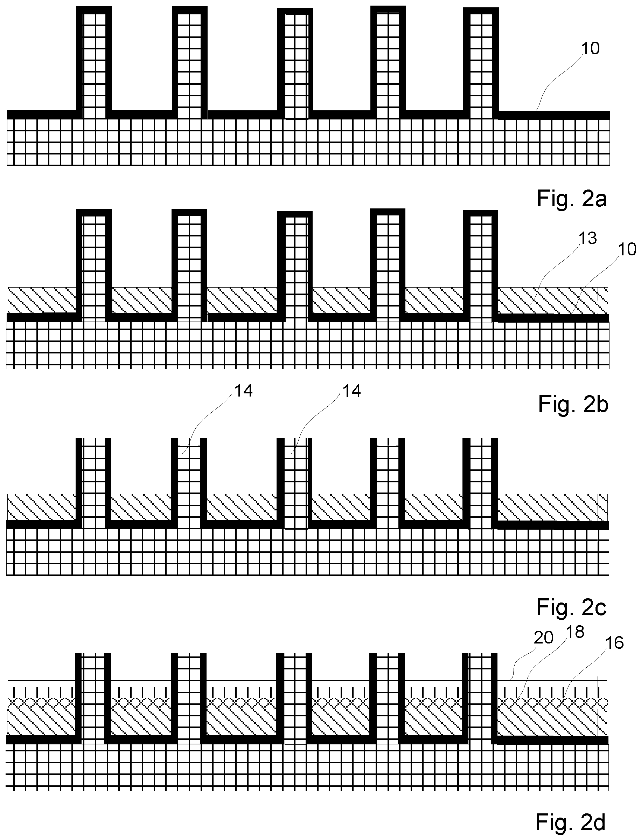

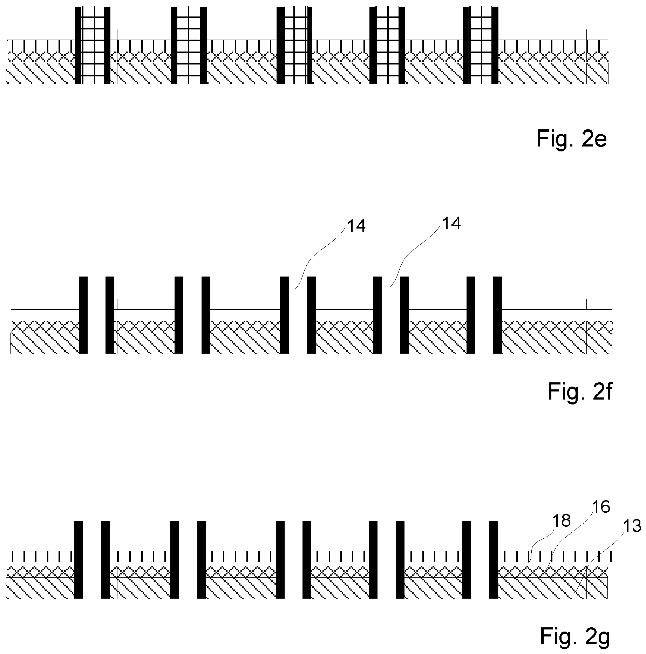

In a final method step, illustrated in Fig. 1e, at least a portion of the lowermost layer (6) is removed such that at least the extremity (8) of the respective nanostructure of the plurality of nanostructures is exposed, i.e. is protruding from the layer. Method of the present invention is alternatively embodied in a similar, although more complex, way, as schematically illustrated in Figs. 2a-2g.

More specifically, as shown in Fig. 2a, the thin oxide layer (10) is isotropically deposited such that the substrate and thereon provided solid elongate nanostructures (nanowires) become covered by said oxide. In this context, while the solid nanowire eventually will be substantially removed, the created oxide-based structure that encapsulates the nanowire, exhibits the same general shape as the nanowire and basically originates from the nanowire, ultimately will incarnate the nanostructure.

As shown in Fig. 2b, a first sacrificial layer (13) is thereafter deposited on top of said oxide layer such that said first sacrificial layer covers at least the exposed regions of the oxide layer. By way of example, material of this first sacrificial layer could be polycarbonate or PNB (polynorbornene). By using sacrificial layers, the nanowires can be made to protrude a well-defined distance. Also, micro- and nanofluidic channel network can be defined to connect the nanowires with biochemical reagents (dyes, DNA, RNA, proteins, salts, drug molecules, gases...). The fluidics network can range in complexity from a simple channel connected to external reservoirs in one end and to the hollow nanowires in the other end to advanced networks capable of multiplexing.

The uppermost portion of the respective nanowire is thereafter removed such that the core of the respective nanowire is exposed, as illustrated in Fig. 2c. This is typically achieved by means of wet or dry etching.

Thereafter, as shown in Fig. 2d, a sequential deposition of several layers ensues. At first, a resilient layer (16) is deposited. By way of example, material of said resilient layer is nylon. Thereafter, a conductive layer (18) is deposited, material of said conductive layer preferably being chosen from the group comprising metals, degenerately doped semiconductors and conductive polymers. Using conducting polymers, metals in thin films or salt solutions in fluidic channels, multiple electrodes can be defined around the nanowires for electrostatic control of the transport in the nanowires. Electrodes realized as gates wrapped around the nanowires are hereby achieved. A sequence of these gates may be arranged so as to control transport of matter through the hollow nanowire. Working principle of this arrangement is extensively described in International Patent Application PCT/SE2012/050098, the content of which is herein incorporated by reference.

Finally, a second sacrificial layer (20) of polycarbonate or PNB is deposited. In this context, deposition of the sacrificial layer serves the purpose of creating future fluidic channel in the structure. In conjunction herewith and as illustrated in Fig. 2g, this second sacrificial layer is removed by selective etching or baking. In the same context, the conductive layer may later on be used as an electrode in order to apply voltage on the nanowire.

Optionally, a plurality of resilient layers, conductive layers and second sacrificial layers is deposited such that said layers uniformly interleave. Obviously, depending on the application, order of deposition of layers may vary.

In the subsequent step, illustrated in Fig, 2e, the substrate and at least a part of the deposited oxide layer are removed. This is normally achieved by non-selective, isotropic etching.

As shown in Fig. 2f, at least a portion of the nanowire core material is removed such that the obtained nanostructures, basically consisting of the oxide layer, become at least partially hollow while the extremity of the respective nanostructure is exposed, i.e. the end section of the respective nanostructure is positioned flush to the surface of the layer. This is normally achieved by means of wet etching. Obviously, in case of hollow nanostructures being provided on the substrate, this step may be omitted. After previously mentioned removal of the second sacrificial layer, shown in Fig. 2g, the entire structure may be transferred onto a non-crystalline layer (substrate).

Accordingly, a structure adapted to be transferred to a non-crystalline layer, by way of example a soft polymer film, a thin metal film (deposited by means of evaporation, sputtering, electroplating, electroless-plating etc.) or an oxide film (deposited by means of evaporation or sputtering), is obtained. In this context, one usable polymer material is parylene. Said structure comprises a plurality of elongate nanostructures and a layer of material, typically a polymer, having, on a macroscopic scale, substantially horizontal upper and lower end surfaces. Said plurality of nanostructures is at least partially embedded in said material such that at least one extremity of the respective nanostructure is exposed. It is hereby ensured that each nanostructure, after having been transferred to a novel substrate, is in direct contact with the novel substrate. In case of tubular nanowires this opens for applications within the field of biofluidics whereby each nanostructure of the transferred structure, when connected to a reservoir containing source material, may be used as an introduction device for introducing this source material, e.g. molecules and/or fluids, into cells. In case of solid nanostructures used inter alia within the field of biofluidics, the exposure of the extremity of each nanostructure makes possible to, via a novel conductive substrate, simultaneously apply voltage on each nanostructure.

By way of example, replacement of the conventional substrate by a completely transparent polymer substrate creates a device that may be of interest for general cell-injection studies. Hereby, optical access to the nanostructures and any thereto connected cells is facilitated. In this context, properties of the novel substrate onto which the created structure is positioned may be tailored to fit a particular application. By way of example, carbon black could be added to the substrate in order to increase its heat absorption.

For some applications, such as in vivo implantation, the novel substrate could be made in a flexible material so that the device becomes foldable and able to adapt its shape to the surrounding. It can, for example, be introduced into the body in a folded state. Once located at the desired place, it can be made to unfold. Fit with a suitably tailored substrate, the device can also better adapt to any movements in the body. Clearly, the high deformability of the novel substrate makes it suitable for in vivo implantation in various different contexts. This includes retinal implants where it can be used as a light detector and neuro-stimulator.

Furthermore, by using patterned sacrificial materials, channels can be made on the novel substrate whereby the integration of advanced fluidics into the manufactured nanostructure based device is facilitated. Still in the context of fluidics, by rendering the novel substrate deformable, microfluidic valves as well as peristaltic micropumps can be implemented. Such a microfluidic valve may be realized by allocating one subset of channels to fluid transport, while the other subset is used to deform the first subset such that an opening/closing action is achieved. In a similar embodiment having the same purpose, a braille display is used to suitably deform the fluid channels. Even integration of optical elements such as optical waveguides is facilitated by use of a novel substrate having tailored properties. More specifically, optical waveguides may be implemented in a transparent substrate to provide optical excitation to the nanostructures or to carry optical signals. As an extension to these passive waveguides, integrated tunable dye lasers may be implemented. Furthermore, the substrate could be made electrically conductive.

The transferrable structure of the present invention may be implemented in a vast range of technologies. Few of these technologies, and the role of the transferrable structure, are briefly described below.

Thus, the structure comprising a plurality of hollow nanostructures may for instance be used as an array of nanosyringes. This confers improved functionality when it comes to precisely controlling injection of molecules into cells and aspiration of molecules from cells. More specifically, a pump design based on gates wrapped around individual nanostructures or on use of pressure- driven flow may be implemented. Here, the novel substrate can be designed such that it contains fluidic channels with integrated valves and pumps to mix and prepare fluids and subsequently transfer the fluids, via nanostructures, to selected cells. In connection herewith, presently used techniques of electroporation and micropipettes are ridden with considerable drawbacks such as poor accuracy (electroporation) and high invasiveness (micropipettes). Moreover, by using claimed structure comprising a plurality of nanostructures, a massive parallelization of the analysis is achieved. Accordingly, a large number of individual cells can be studied in parallel. Biomedical applications of these nanosyringes include inter alia studies within the fields of cancer biology, drug screening, cell heterogeneity, systems biology, cell differentiation and stem cell biology. Namely, in all these fields there is an interest in both introducing a controlled amount of molecules into a cell and monitoring the biochemical composition of the cell. Furthermore, use of nanostructures opens up for the extraction of entire organelles and other structures from inside a cell (nanobiopsy). For example, mitochondria could be targeted and extracted from the cytosol.

Also, a multilayer structure comprising a plurality of solid nanowires transferred on a novel polymer substrate is conceivable for solar energy applications. In contrast to conventional, non-flexible substrates, the polymer substrate can be made transparent for the relevant wavelengths and it is inherently elastically deformable. This flexibility allows for the transferred structure comprising the novel substrate to roll up. The rolls are subsequently packed. This maximizes the amount of light absorbed by the nanowires for a given device volume. A thin reflective coating could also be applied in order to make sure that the light passes twice through the device such that light absorption is increased. Using layers with different levels of stress, one could make the transferrable structure roll up spontaneously once released from a solid substrate. This type of dynamic substrate could also be used actively to tune the interaction between the integrated nanowires and the surrounding tissue or attached cells. It is well-known in the art that differentiation of cells and formation of tissue is governed not only by biochemical signals but also by mechanical stimulation.
Another envisageable application field is tissue engineering. More specifically, it is known that tissue forms as a response to the interaction between cells and their topographical, mechanical and chemical surrounding. In tissue engineering these cues are used to create artificial tissue. The structure comprising a plurality of nanostructures according to the invention, once integrated into a scaffold of desired mechanical properties, could then provide an additional tool in tissue engineering so as to e.g. guide cell growth, give a specific mechanical property to a surface, to act as in-situ sensors and to deliver specific chemicals with high temporal and spatial resolution during tissue growth.

Furthermore, the claimed structure, once transferred onto a soft polymer substrate, can serve to guide growth of neurons with applications for neural implants to motor neurons, sensory neurons and to connect damaged neurons, i.e. guide regrowth of neurons.

The previously mentioned integrated fluidics can be used to deliver specific chemicals with high temporal and spatial resolution during the growth of the neurons whereas, by using optical waveguides, light can be delivered with high temporal and spatial resolution to stimulate the neurons.

Another example is the field of deep-brain stimulation. A small current is applied to specific areas of the brain to treat for example Parkinson's disease, tremor and chronic pain. With the claimed structure precise localization of the stimulation can be made in the body and with the soft substrate any biological incompatibility is minimized. In the same context, for other medical conditions chemical or optical stimulation may be suitable.

Yet another example is a sensor based on the fact that the structure comprising nanowires can be used for mechanical, chemical and electrical sensing. Transferred to a novel, soft substrate, nanowire-based sensors can be implanted for monitoring of e.g. wound healing, tissue growth, neural and endocrine activity. A further example is to use the polymer substrate with fluidics as a dynamical object, i.e.an object that moves and thus mechanically stimulates the surrounding tissue. The channels of the substrate are filled with pressurized liquid or gas such that the pressure inside the channels is changed whereby the shape of the substrate also is changed.

The nanostructures of the transferrable structure may also be used for encapsulating single cells or aggregates.

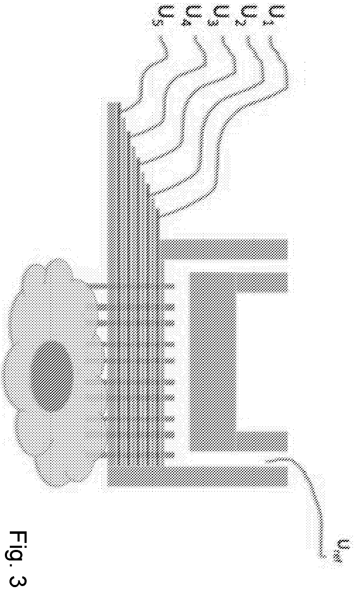

Fig. 3 shows an exemplary device including a structure manufactured using the claimed method, said device comprising hollow nanostructures and being suitable for application within the field of biofluidics. Here, a U-shaped fluidics architecture ensures that the liquids can be exchanged efficiently. For introduction of a solution into the device, a pressure difference is applied along the large channel. Subsequently, a pressure difference applied across the length of the nanostructures can be used to transport the solution into the cell or the contents of the cell into the solution. An alternative is to use the electrodes to pump charged molecules into or out of the cell. In this particular case the novel substrate encompasses two functionalities in addition to holding the nanowires in place. Firstly, layers of conductive material separated by dielectric materials and connected to voltage sources can be used as gates controlling the transport in through the hollow nanowires. Secondly, a schematic fluidic structure is integrated in the substrate to provide buffer of desired composition to selected cells.

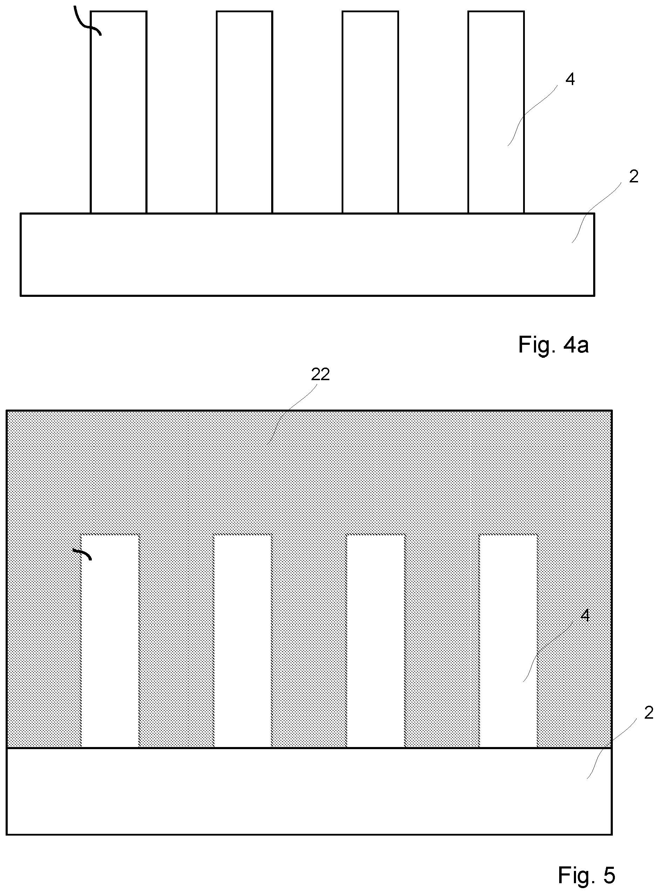

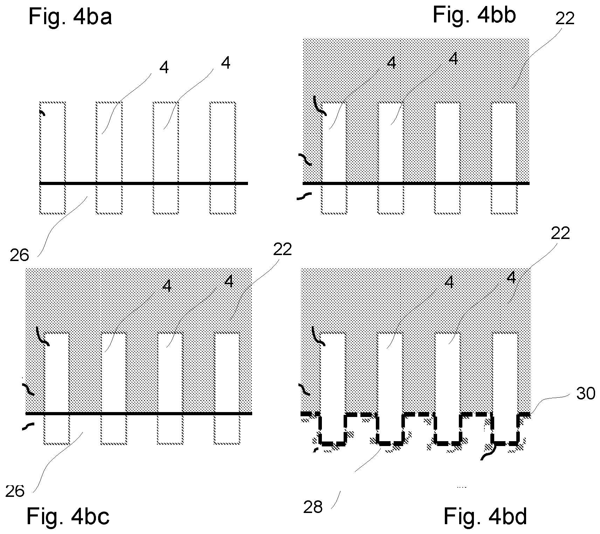

In another embodiment, illustrated in Figs. 4a - 8, a versatile nanowire-based structure is obtained that may have numerous applications, e.g. opto-electric devices such as solar cells and light emitting diodes. Here, the term nanowire is used to denote an elongate nanostructure.

First of all, as illustrated in Fig. 4a, a hard substrate is provided with nanowires being positioned on said substrate. An alternative to this configuration is shown in Fig. 4b - nanowires are partially immersed in a liquid and aligned. These embodiments are only exemplary and it is to be understood that material of future nanowires may be supplied by a gas-phase reaction, i.e. aerotaxially™ grown, or in a liquid solution or traditionally substrate-grown. The nanowires may be deposited on conventional hard substrates, but also, as in Fig. 4b, be at least partially immersed in an aggregately different base material such as liquid playing the role of the conventional substrate. Indeed, the interface between a substrate and stream of supplied nanowire building material may be any of a solid/gas, liquid/gas, solid/liquid, liquid/liquid.

Nanowires could be semiconductor nanowires made from Si, SiC, GaP, InP, GaAs, GaN, GaAs, InP, InAs and InN, ternary compounds such as GaAsxP1-x, InxGa1-xP and GaxIn1-xN, and even quaternary compounds such as InGaAsP and InGaAsSb. The nanowires of Figs. 4a and 4b could be grown epitaxially from a nanoscale catalytic gold particle, grown selectively through apertures in a mask or assembled or deposited at the interface from gas phase or liquid solution. These nanowires extend from the substrate such that the angle defined by the axis of elongation of each nanostructure and the surface normal of the substrate is smaller than 55 degrees. In a non-limiting embodiment, mean axis of elongation of nanowires coincides within 35 degrees from the surface normal of the substrate. Regardless of choice of the substrate the mean angle defined by the axis of elongation of each nanostructure and the surface normal of the substrate is smaller than 55 degrees. These elongate nanostructures may be epitaxially connected to the surface or assembled onto the surface from liquid or gas phase nanowire solutions. In these cases position and orientation of the nanowires may be controlled with great precision. Alternatively, provided nanowires may be less precisely arranged, such as nanowires deposited using aerotaxy. In this context, it is possible that nanowires having different orientations are present on the same substrate. Nanowires could also adopt tree-like structures.

In a further step, visualised in Fig. 5, at least one layer of material is deposited such that the nanowires are basically embedded in said material. By way of example, a polymer film exhibiting suitable dielectric and elastic properties is coated onto the substrate. As it may be seen in Fig. 5, the deposited film covers not only the exposed regions of the substrate, but also completely covers the nanowires, in most cases to a thickness much greater than the height of the nanowires. Polydimethylsiloxane (PDMS) and other silicones are examples of materials suitable for this purpose, but the invention is by no means limited to these.

The thickness of the applied film is typically much greater than the height of the nanowires. For instance, direct band gap material nanowires such as those made in GaAs may be on the order of 1-3 µm tall, whereas the thickness of the film embedding them may be > 10 µm, most often even > 20 µm. It is primarily the mechanical properties of the film and the method of applying it that determines its final thickness. In connection herewith, due to the relaxed thickness requirement, the method of applying the film can be a high throughput method. For instance, spraying, spin-coating, brushing, dipping or any combination thereof are all conceivable applying methods.

According to the invention, the applied film comprises at least two layers, wherein the first layer, deposited directly onto the substrate, has a different chemical composition than a second layer formed on top of the first layer, both layers embedding parts of the nanowires. Then the second layer can be used as an etch stop for the first layer, when selective etching is employed. According to the invention the first layer is an oxide and the second layer being may be a polymer layer deposited thereupon.

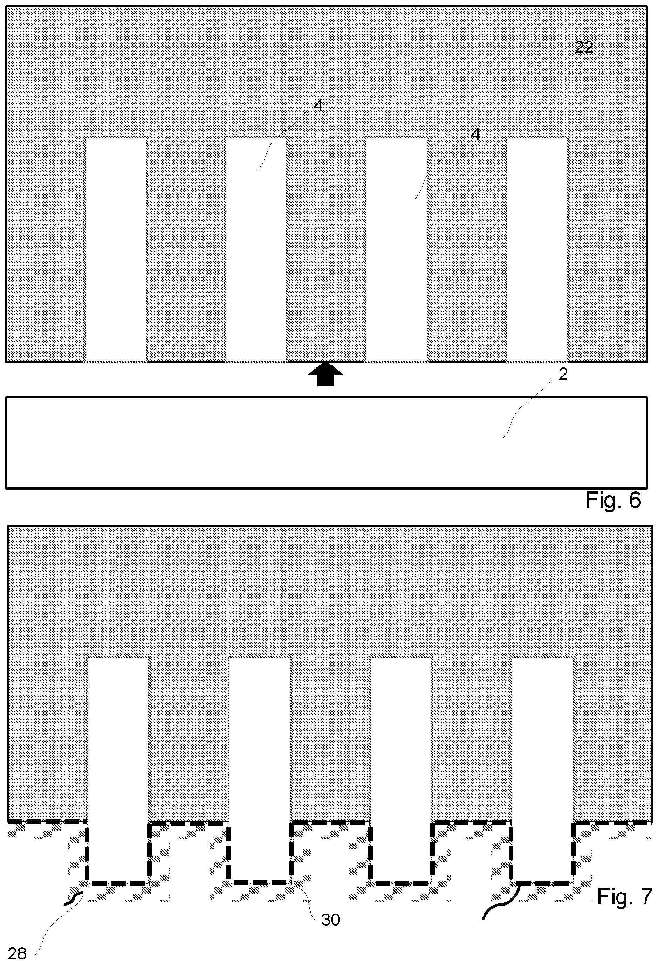

As shown in Fig. 6, the substrate is mechanically or chemically removed such that the previously applied polymer film becomes lowermost layer. By way of example, the removal may be effected through peeling off the polymer matrix comprising the nanostructures from the substrate.

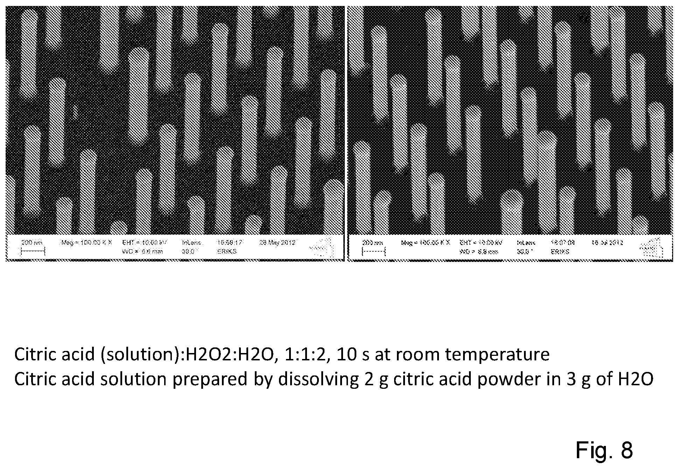

Optionally, an etch step, visualised in Fig. 8, may be carried out prior to applying the polymer film and in order to facilitate mechanical removal of the nanowires. The etch step should selectively etch a region of the nanowire close to the substrate. The selectivity of the etch could have different origins, for instance etch rate could depend on orientation or composition of the nanowire in the area under consideration. For instance, the result of one possible etch is shown in Fig. 8, as performed on a GaAs nanowire array. Here a solution of citric acid in de-ionized water was prepared (2 g of citric acid [in solid state] to 3 g of de-ionized water, thus making the citric acid solution). This solution was further mixed with hydrogen peroxide and de-ionized water. The proportions were 1 part citric acid solution: 1 part H2O2 : 2 parts H2O, and the etch at room temperature that lasted 10 s with typical etch times of 5-10 s to produce this result with this particular etch. One factor that affects the etch result in this case is the dependence of the etch rate on orientation. Other wet or dry etches may be used that produce similar results for the purposes here stated and the inclusion of this step should not be seen as limited to this specific etch and this specific material.

Exemplifying the above, GaAs nanowires with diameter in the 100-160 nm range and length above 2 µm could be embedded with approximately 100 µm thick film of PDMS and then successfully mechanically removed even without the inclusion of the etch step. If the etch step is to be included, the process range is extended to enable layer transfer of wires shorter than 2 µm. The process range will be dependent on nanowire material and dimensional properties, such as aspect ratio, as well as the properties and dimensions of the polymer film and needs to be determined experimentally.

The lower extremity of the respective nanowire is then exposed, i.e. it is made to protrude from the film (not shown). This is achieved either by removing a portion of the film, or, in case where the nanowires penetrated the original base material, as illustrated in Fig. 4ba-4bd, the removal of said material automatically exposes the nanowires. In this case, the polymer material is selected based on other criteria than if the substrate is a solid. In this case, maintaining a stable surface and chemical compatibility with the liquid are essential. The corresponding method sequence is illustrated in Fig 4ba through 4bd.

A backing layer, shown in Fig. 7, that surrounds the protruding section of the respective nanowire can be created. Its creation may involve one or multiple material depositions. The backing layer may have the purpose of creating contacts to the nanowire and/or mechanical protection and support. For instance, the sheet with aligned nanowires could be shipped on a roll or multiple sheets may be shipped stacked together, causing damage to the protruding ends if not encapsulated at least temporarily during transport. The backing layer may be conducting or non-conducting, it may form a transparent or non-transparent electrical contact to the nanostructure and the stabilizing properties are greatly improved by a micro-structured interface 30 formed by the protruding nanostructures, the polymer film and the backing layer. The micro-structured interface 30 is also shown in Fig. 4bd.

Accordingly, as shown in Fig. 7, a nanostructure is fabricated where the nanowires are completely embedded in the polymer film, and firmly anchored in the backing layer. Similarly with the structure discussed in connection with Figs. 1-3, the obtained structure of Fig. 7 is adapted to be transferred to a non-crystalline layer, by way of example a soft polymer film or a thin metal film (deposited by means of evaporation, sputtering, electroplating, electroless-plating etc.) or an oxide film (deposited by means of evaporation or sputtering). In this context, one usable polymer material is parylene.

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A method of manufacturing a structure comprising a plurality of elongate nanostructures, adapted to be transferred to a noncrystalline layer, said method comprising the steps of:
- providing a substrate (2),
- providing a plurality of elongate nanostructures (4) on said substrate, said nanostructures extending from the substrate such that the angle defined by the axis of elongation of each nanostructure and the surface normal of the substrate is smaller than 55 degrees,
- depositing at least one layer of material (6) after the provision of the plurality of elongate nanostructures, such that at least the exposed regions of the substrate are covered by said material,
wherein said depositing step comprises depositing at least two layers, comprising an isotropically deposited oxide layer directly on the substrate and a further deposited layer (6),
- removing the substrate (2) and after that removing said oxide layer, such that the further deposited layer (6) becomes the lowermost layer,
- exposing at least the lower extremities (8) of the respective elongate nanostructures (4) of the plurality of elongate nanostructures.

2. A method according to claim 1, wherein said lowermost layer is a single layer.

3. A method according to any of the preceding claims, wherein the depositing step comprises deposition of a polymer material.

4. A method according to any of the preceding claims,
said method further comprising the step of depositing a first sacrificial layer (13), material of said first sacrificial layer preferably being polycarbonate and/or PNB, wherein said first sacrificial layer is deposited on top of said oxide layer such that said first sacrificial layer covers at least the exposed regions of the oxide layer.

5. A method according to any of the preceding claims, said method further comprising the step of removing the uppermost portion of the respective nanostructure such that the core (14) of the respective nanostructure is exposed, and wherein said removing is achieved by means of wet or dry etching.

6. A method according to any of the preceding claims, said method further comprising the step of depositing at least one resilient layer (16), material of said resilient layer preferably being nylon, or
said method further comprising the step of depositing at least one conductive layer (18), material of said conductive layer preferably being chosen from the group comprising metals, degenerately doped semiconductors and conductive polymers, or
said method further comprising the step of depositing at least one second sacrificial layer (20).

7. A method according to claim 6, wherein a plurality of resilient layers, conductive layers and second sacrificial layers is deposited such that said layers uniformly interleave.

8. A method according to claims 4-7, said method further comprising the step of at least partially removing said oxide layer,
wherein said removing of the oxide layer is achieved by non-selective, isotropic etching,
said method further comprising the step of removing at least a portion of the nanostructure core material such that said nanostructure becomes at least partially hollow, and
wherein said removing is achieved by means of wet etching.

9. A method according to claims 4-8, wherein at least one of the first (13) and second (20) sacrificial layer is removed, and
wherein said removing of the sacrificial layer is achieved by selective etching or baking.

10. A method according to claim 1, further comprising the step of removing at least a portion of the lowermost layer such that at least the extremity (8) of the respective nanostructure of the plurality of nanostructures is exposed.

11. A method according to claim 1, wherein the respective nanostructures of the plurality of nanostructures are initially completely embedded in the deposited layer of material (22), said material being a polymer,
wherein an etching step is carried out prior to depositing the material.

12. A method according to claim 1, wherein the respective nanostructures of the plurality of nanostructures are at least partially immersed in a liquid (26) prior to depositing of the at least one layer of material,
wherein said substrate is mechanically or chemically removed,
said method further comprising the step of depositing a conductive layer (28) onto the exposed extremity of the respective nanostructure such that the deposited conductive layer becomes the lowermost layer,
said method further comprising the step of transferring the obtained structure onto a non-crystalline layer.

## Patentansprüche

1. Verfahren zur Herstellung einer Struktur mit mehreren länglichen Nanostrukturen, die zur Übertragung auf eine nichtkristalline Schicht ausgelegt sind, wobei das Verfahren die folgenden Schritte umfasst:
- Bereitstellen eines Substrats (2),
- Bereitstellen mehrerer länglicher Nanostrukturen (4) auf dem Substrat, wobei sich die Nanostrukturen von dem Substrat erstrecken, sodass der Winkel, der von der Verlängerungsachse jeder Nanostruktur und der Oberfläche definiert wird, die normal zum Substrat verläuft, kleiner als 55 Grad ist,
- Abscheiden mindestens einer Materialschicht (6) nach Bereitstellen der mehreren länglichen Nanostrukturen, sodass mindestens die freigelegten Bereiche des Substrats von dem Material bedeckt werden,
wobei der Abscheidungsschritt das Abscheiden von mindestens zwei Schichten umfasst, umfassend eine isotrop abgeschiedene Oxidschicht direkt auf dem Substrat und eine weitere abgeschiedene Schicht (6),
- Entfernen des Substrats (2) und danach Entfernen der Oxidschicht, so dass die weitere abgeschiedene Schicht (6) die unterste Schicht wird,
- Freilegen mindestens der unteren Enden (8) der jeweiligen länglichen Nanostrukturen (4) der mehreren länglichen Nanostrukturen.

2. Verfahren nach Anspruch 1, wobei die unterste Schicht eine einzelne Schicht ist.

3. Verfahren nach einem der vorhergehenden Ansprüche, wobei der Abscheidungsschritt das Abscheiden eines Polymermaterials umfasst.

4. Verfahren nach einem der vorhergehenden Ansprüche, wobei das Verfahren ferner den Schritt des Abscheidens einer ersten Opferschicht (13) umfasst, wobei das Material der ersten Opferschicht vorzugsweise Polycarbonat und/oder PNB ist, wobei die erste Opferschicht auf der Oberseite der Oxidschicht abgeschieden ist, sodass die erste Opferschicht mindestens die freigelegten Bereiche der Oxidschicht abdeckt.

5. Verfahren nach einem der vorhergehenden Ansprüche, wobei das Verfahren ferner den Schritt des Entfernens des obersten Anteils der jeweiligen Nanostruktur umfasst, sodass der Kern (14) der jeweiligen Nanostruktur freigelegt wird, und wobei das Entfernen mittels Nass-oder Trockenätzen erreicht wird.

6. Verfahren nach einem der vorhergehenden Ansprüche, wobei das Verfahren ferner den Schritt des Abscheidens mindestens einer elastischen Schicht (16) umfasst, wobei das Material der elastischen Schicht vorzugsweise Nylon ist, oder wobei das Verfahren ferner den Schritt des Abscheidens mindestens einer leitfähigen Schicht (18) umfasst, wobei das Material der leitfähigen Schicht vorzugsweise ausgewählt ist aus der Gruppe, umfassend Metalle, entartet dotierte Halbleiter und leitfähige Polymere, oder wobei das Verfahren ferner den Schritt des Abscheidens mindestens einer zweiten Opferschicht (20) umfasst.

7. Verfahren nach Anspruch 6, wobei mehrere elastische Schichten, leitfähige Schichten und zweite Opferschichten abgeschieden werden, sodass sich die Schichten einheitlich verschachteln.

8. Verfahren nach den Ansprüchen 4-7, wobei das Verfahren ferner den Schritt des mindestens teilweise Entfernens der Oxidschicht umfasst,
wobei das Entfernen der Oxidschicht durch nicht selektives, isotropes Ätzen erreicht wird,
wobei das Verfahren ferner den Schritt des Entfernens mindestens eines Anteils des Nanostrukturkernmaterials umfasst, sodass die Nanostruktur mindestens teilweise hohl wird, und
wobei das Entfernen durch Nassätzen erreicht wird.

9. Verfahren nach den Ansprüchen 4-8, wobei mindestens entweder die erste (13) oder zweite (20) Opferschicht entfernt werden, und
wobei das Entfernen der Opferschicht durch selektives Ätzen oder Backen erreicht wird.

10. Verfahren nach Anspruch 1, weiterhin umfassend den Schritt des Entfernens mindestens eines Anteils der untersten Schicht, sodass mindestens das Ende (8) der jeweiligen Nanostruktur der mehreren Nanostrukturen freigelegt wird.

11. Verfahren nach Anspruch 1, wobei die jeweiligen Nanostrukturen der mehreren Nanostrukturen anfangs vollständig in der abgeschiedenen Schicht des Materials (22) eingebettet sind, wobei das Material ein Polymer ist,
wobei ein Ätzschritt vor dem Abscheiden des Materials ausgeführt wird.

12. Verfahren nach Anspruch 1, wobei die jeweiligen Nanostrukturen der mehreren Nanostrukturen mindestens teilweise in einer Flüssigkeit (26) vor dem Abscheiden der mindestens einen Materialschicht eingetaucht sind,
wobei das Substrat mechanisch oder chemisch entfernt wird, wobei das Verfahren ferner den Schritt des Abscheidens einer leitfähigen Schicht (28) auf das freigelegte Ende der jeweiligen Nanostruktur umfasst, sodass die abgeschiedene leitfähige Schicht die unterste Schicht wird,
wobei das Verfahren ferner den Schritt des Übertragens der erhaltenen Struktur auf eine nichtkristalline Schicht umfasst.

## Revendications

1. Procédé de fabrication d'une structure comprenant une pluralité de nanostructures allongées, conçue pour être transférée à une couche non cristalline, ledit procédé comprenant les étapes qui consistent à :
- fournir un substrat (2),
- placer une pluralité de nanostructures allongées (4) sur ledit substrat, lesdites nanostructures s'étendant à partir du substrat de telle sorte que l'angle formé par l'axe d'allongement de chaque nanostructure et la normale de surface du substrat soit inférieur à 55 degrés,
- déposer au moins une couche de matériau (6) après avoir placé la pluralité de nanostructures allongées, de telle sorte qu'au moins les régions exposées du substrat soient recouvertes par ledit matériau,
dans lequel ladite étape de dépôt comprend le dépôt d'au moins deux couches, comprenant une couche d'oxyde déposée par un procédé isotrope directement sur le substrat et une autre couche déposée (6),
- éliminer le substrat (2), puis éliminer ladite couche d'oxyde, de telle sorte que l'autre couche déposée (6) devienne la couche la plus basse,
- exposer au moins les extrémités inférieures (8) des nanostructures allongées respectives (4) de la pluralité de nanostructures allongées.

2. Procédé selon la revendication 1, dans lequel ladite couche la plus basse est une seule couche.

3. Procédé selon l'une quelconque des revendications précédentes, dans lequel l'étape de dépôt comprend le dépôt d'un matériau polymère.

4. Procédé selon l'une quelconque des revendications précédentes, ledit procédé comprenant en outre l'étape de dépôt d'une première couche sacrificielle (13), le matériau de ladite première couche sacrificielle étant préférablement un polycarbonate et/ou du PNB, ladite première couche sacrificielle étant déposée sur le dessus de ladite couche d'oxyde de telle sorte que ladite première couche sacrificielle recouvre au moins les régions exposées de la couche d'oxyde.

5. Procédé selon l'une quelconque des revendications précédentes, ledit procédé comprenant en outre l'étape d'élimination de la partie la plus haute de la nanostructure respective de telle sorte que la partie centrale (14) de la nanostructure respective soit exposée, et ladite élimination étant réalisée par attaque chimique humide ou sèche.

6. Procédé selon l'une quelconque des revendications précédentes, ledit procédé comprenant en outre l'étape de dépôt d'au moins une couche résiliente (16), le matériau de ladite couche résiliente étant de préférence du nylon, ou
ledit procédé comprenant en outre l'étape de dépôt d'au moins une couche conductrice (18), le matériau de ladite couche conductrice étant préférablement choisi dans le groupe comprenant des métaux, des semi-conducteurs dopés dégénérés et des polymères conducteurs, ou
ledit procédé comprenant en outre l'étape de dépôt d'au moins une deuxième couche sacrificielle (20) .

7. Procédé selon la revendication 6, dans lequel une pluralité de couches résilientes, de couches conductrices et de deuxièmes couches sacrificielles est déposée de telle sorte que lesdites couches s'imbriquent uniformément.

8. Procédé selon les revendications 4 à 7, ledit procédé comprenant en outre l'étape d'élimination au moins partielle de ladite couche d'oxyde,
dans lequel ladite élimination de la couche d'oxyde est réalisée par attaque chimique non sélective et isotrope,
ledit procédé comprenant en outre l'étape d'élimination d'au moins une partie du matériau central de la nanostructure de telle sorte que ladite nanostructure devienne au moins en partie creuse, et
dans lequel ladite élimination est réalisée par attaque chimique humide.

9. Procédé selon les revendications 4 à 8, dans lequel au moins une de la première couche sacrificielle (13) et de la deuxième couche sacrificielle (20) est éliminée, et
dans lequel ladite élimination de la couche sacrificielle est réalisée par attaque chimique sélective ou cuisson.

10. Procédé selon la revendication 1, comprenant en outre l'étape d'élimination d'au moins une partie de la couche la plus basse de telle sorte qu'au moins l'extrémité (8) de la nanostructure respective de la pluralité de nanostructures soit exposée.

11. Procédé selon la revendication 1, dans lequel les nanostructures respectives de la pluralité de nanostructures sont initialement entièrement enrobées dans la couche de matériau déposée (22), ledit matériau étant un polymère,
dans lequel une étape d'attaque chimique est exécutée avant le dépôt du matériau.

12. Procédé selon la revendication 1, dans lequel les nanostructures respectives de la pluralité de nanostructures sont au moins en partie immergées dans un liquide (26) avant le dépôt de ladite au moins une couche de matériau,
dans lequel ledit substrat est éliminé par un procédé mécanique ou chimique,
ledit procédé comprenant en outre l'étape de dépôt d'une couche conductrice (28) sur l'extrémité exposée de la nanostructure respective de telle sorte que la couche conductrice déposée devienne la couche la plus basse,
ledit procédé comprenant en outre l'étape de transfert de la structure obtenue sur une couche non cristalline.
